# FASCICULE DE BREVET EUROPEEN

(11) **EP 4 109 689 B1**
(45) Date de publication et mention de la délivrance du brevet: **11.06.2025**
(21) Numéro de dépôt: 22179792.1
(22) Date de dépôt: 20.06.2022
(51) Int. Cl.: H02B 1/28, H02B 1/20

(54) **ARMOIRE ÉLECTRIQUE COMPORTANT UN ÉLÉMENT ÉLECTRIQUEMENT ISOLANT**
SCHALTSCHRANK MIT EINEM ELEKTRISCH ISOLIERENDEN ELEMENT
ELECTRICAL CABINET COMPRISING AN ELECTRICALLY INSULATING ELEMENT

(30) Priorité: 21.06.2021 FR 2106549
(43) Date de publication de la demande: 28.12.2022
(73) Titulaire: Schneider Electric Industries SAS, 92500 Rueil-Malmaison (FR)
(72) Inventeur: BADIN, Didier, 38400 SAINT MARTIN D'HERES (FR); ROTA, Angelo, 20063 CERNUSCO SUL NAVIGLIO (IT); BLOCHOUSE, Philippe, 73290 LA MOTTE SERVOLEX (FR)
(74) Mandataire: Lavoix

(56) Documents cités:
- DE-A1- 102016 202 212
- DE-A1- 102018 106 252
- US-A- 5 326 934
- US-A1- 2009 025 957

## Description

La présente invention concerne une armoire électrique.

De façon connue, les installations de distribution d'électricité comporte des armoires électriques, ou coffrets électriques, dans lesquels sont placés des appareils électriques, tels que des appareils de protection électrique ou des appareils de commutation électrique et/ou des éléments d'interconnexion électrique, tels que des barres de raccordement.

Les armoires électriques doivent répondre à des exigences parfois importantes en terme de sécurité électrique. Par exemple, les armoires électriques de type « Classe Il » au sens de la norme IEC 61140 de la Commission Électrotechnique Internationale doivent présenter une isolation électrique renforcée et sont typiquement configurées pour qu'aucun élément conducteur susceptible d'être traversé par le courant électrique distribué par l'installation ne soit accessible par un utilisateur.

Pour ce faire, les armoires électriques existantes prévoient de séparer les éléments alimentés électriquement des éléments accessibles à un utilisateur ouvrant l'armoire au moyen de compartiments distincts, voire en ayant recours à deux coffrets distincts. Cette solution a cependant pour inconvénient d'être particulièrement encombrante, en plus d'être coûteuse et plus longue à installer.

En effet, dans de nombreux cas, l'armoire électrique doit aujourd'hui être construite et assemblée sur mesure par un installateur. Les solutions standardisées vendues en kit ne sont pas toujours appropriées, car elles ne permettent pas toujours d'obtenir nativement une protection électrique de classe II.

DE 10 2018 106252 A1 et DE 10 2016 202212 A1 décrivent chacun une armoire électrique avec des chemins de câblage qui sont obturés, à une ouverture d'extrémité, par des pièces de fermeture reçues dans le chemin de câblage. US 2009/025957 A1 décrit, quant à lui, un chemin de câblage avec un couvercle d'extrémité peu encombrant. US 5326934 A décrit, quant à lui, un pied de porte de travail informatique prévu pour laisser passer des câbles.

C'est à ces inconvénients qu'entend plus particulièrement remédier l'invention en proposant une armoire électrique présentant une isolation électrique de classe II.

À cet effet, un aspect de l'invention concerne une armoire électrique selon la revendication 1.

Selon des aspects avantageux mais non obligatoires, une telle armoire électrique peut incorporer une ou plusieurs des caractéristiques suivantes, prises isolément ou suivant toute combinaison techniquement admissible :
- la pièce de jonction comporte des griffes de fixation configurées pour exercer un effort sur la colonne lorsque la pièce de jonction est insérée dans la colonne.
- les griffes de fixation sont configurées pour dépasser au moins en partie d'une l'extrémité supérieure de la colonne pour s'appuyer sur un bord supérieur de la colonne.
- la pièce de jonction une pièce monobloc construite d'un seul tenant.
- la pièce de jonction est construite en matière plastique, par exemple par moulage ou par injection.

L'invention sera mieux comprise et d'autres avantages de celle-ci apparaîtront plus clairement à la lumière de la description qui va suivre d'un mode de réalisation d'une armoire électrique donnée uniquement à titre d'exemple et faite en référence aux dessins annexés, dans lesquels :
[Fig 1] la figure 1 représente schématiquement, selon une vue éclatée, une armoire électrique conforme à des modes de réalisation de l'invention ;
[Fig 2] la figure 2 représente schématiquement l'armoire électrique de la figure 1 illustrée dans une configuration assemblée ;
[Fig 3] la figure 3 est une vue détaillée de la zone III de la figure 2, illustrant un partie d'un élément de séparation utilisé dans l'armoire électrique des figures 1 et 2 ;
[Fig 4] la figure 4 représente schématiquement l'élément de séparation de la figure 3 selon des modes de réalisation de l'invention.

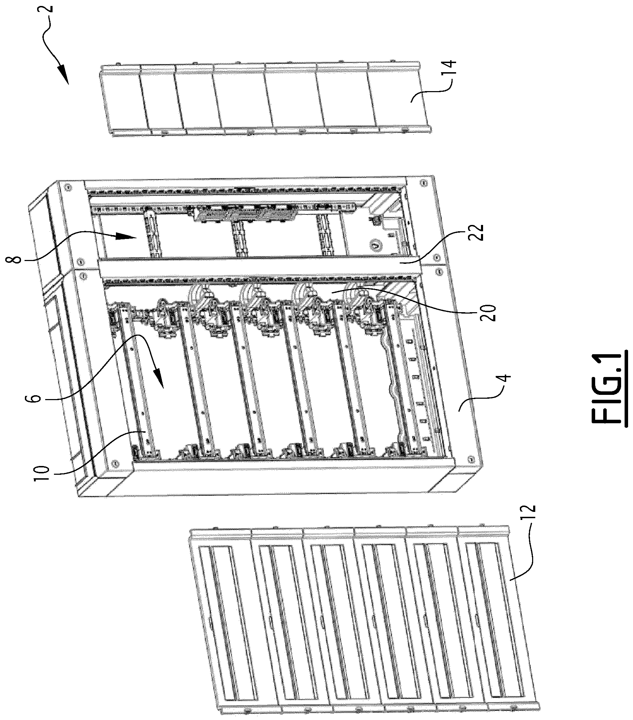

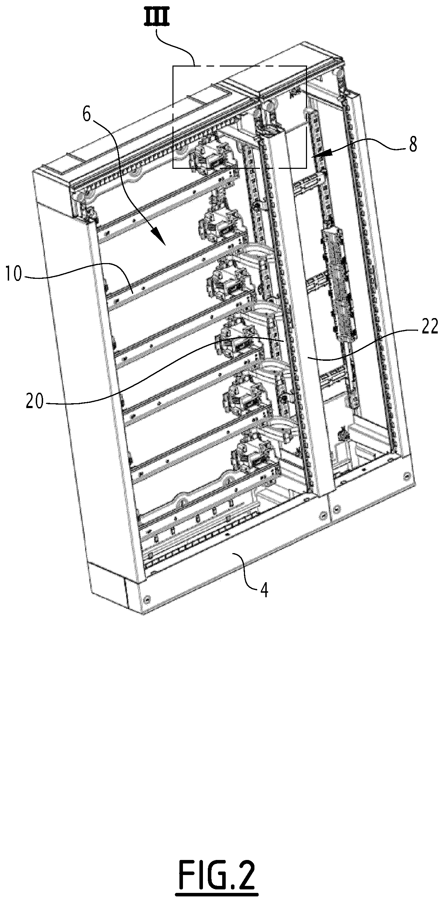

La figure 1 et la figure 2 représentent une armoire électrique 2 comportant des parois 4 formant une armature extérieure et délimitant un volume intérieur.

Par exemple, les parois sont formées en matière métallique. Par exemple, il peut s'agir de panneaux métalliques fixés entre eux par tout moyen approprié, notamment par vissage, ou par boulonnage, ou au moyen d'éléments de fixation intégrés aux plaques et présentant des formes complémentaires.

Dans l'exemple illustré, l'armoire électrique 2 présente une forme de pavé à base rectangulaire.

L'armoire électrique 2 peut être configurée pour être montée sur un support, tel qu'un mur, ou bien être posée au sol ou fixée au sol.

Dans ce qui suit, l'armoire électrique 2 peut également être nommée « coffret électrique ».

De préférence, l'intérieur de l'armoire électrique 2 est partagé entre un premier compartiment 6 et un deuxième compartiment 8. Par exemple, le premier compartiment 6 et le deuxième compartiment 8 peuvent être en communication l'un avec l'autre. En d'autres termes, le premier compartiment 6 et le deuxième compartiment 8 ne sont pas nécessairement complètement isolés l'un de l'autre par une paroi ou un mur interne.

Par exemple, le premier compartiment 6 peut comporter une ou plusieurs barres de fixation 10 qui permettent de monter un ou plusieurs appareils électriques à l'intérieur de l'armoire électrique 2. Dans l'exemple illustré, les barres de fixation 10 sont disposées horizontalement.

Ainsi, les appareils électriques peuvent être disposés dans l'armoire électrique 2 sous la forme de rangées superposées les unes au-dessus des autres. Par exemple, le nombre de rangées est supérieur ou égal à 2. Le nombre de rangées est, par exemple, inférieur ou égal à 10.

Selon des modes de réalisation, donnés à titre d'exemple illustratif, les appareils électriques peuvent être des appareils de protection électrique, tels que des disjoncteurs, ou des appareils de commutation électrique, tels que des contacteurs, ou des relais, ou tout appareil équivalent, ces exemples n'étant pas limitatifs.

Un ou plusieurs orifices peuvent être ménagés dans une ou plusieurs des parois 4 de l'armoire électrique 2 afin d'autoriser le passage de câbles électriques vers l'intérieur de l'armoire électrique 2.

L'armoire électrique 2 comporte ici des panneaux de façade qui permettent à un utilisateur, tel qu'un opérateur de maintenance ou un installateur, d'accéder à l'intérieur de l'armoire électrique 2, par exemple pour installer ou intervenir sur des appareils électriques dans l'armoire électrique 2. Ces panneaux de façade dont de préférence montés sur une face avant de l'armoire électrique 2.

Par exemple, le premier compartiment 6 est fermé par au moins un premier panneau de façade 12 et le deuxième compartiment 8 est fermé par au moins un deuxième panneau de façade.

Selon des modes de réalisation, les panneaux de façade peuvent comporter chacun une porte ou un panneau amovible, par exemple monté pivotant ou coulissant, ces exemples n'étant pas limitatifs.

Par exemple, comme illustré sur la figure 1 par le panneau de façade 12, au moins une partie des panneaux de façade peuvent comporter une ouverture permettant d'accéder à l'intérieur de l'armoire électrique 2.

Les panneaux de façade peuvent s'étendre sur toute la hauteur de l'armoire électrique 2, ou seulement sur une partie de cette hauteur.

Par exemple, chaque panneau de façade présente une hauteur correspondant à la hauteur d'une rangée d'appareils électriques installés dans l'armoire électrique 2. Ainsi, les panneaux peuvent être ouverts indépendamment les uns des autres pour n'accéder qu'à une partie des appareils électriques.

L'armoire électrique 2 comporte également une colonne 20 permettant le passage d'un ou de plusieurs câbles électriques dans l'armoire électrique 2, voire d'un faisceau de câbles électriques. La colonne 20 correspond ici à une zone d'interface entre le premier compartiment 6 et le deuxième compartiment 8. Par exemple, le ou les câbles électriques sont destinés à être raccordés à un ou à plusieurs des appareils électriques de l'armoire.

La colonne 20 est disposée verticalement à l'intérieur de l'armoire électrique. Par exemple, la colonne 20 s'étend sur au moins une partie de la hauteur interne de l'armoire électrique 2, par exemple sur plus de 50% ou plus de 75% de la hauteur interne (i.e. mesurée à l'intérieur) de l'armoire électrique 2.

Dans l'exemple illustré, la colonne 20 sépare au moins en partie le premier compartiment 6 du deuxième compartiment 8 (ce dernier pouvant aussi être nommé « gaine »).

Par exemple, la colonne 20 peut être fermée sur sa face avant par une pièce de façade 22, telle qu'un longeron 22, de préférence réalisé en matière métallique.

La pièce de façade 22 présente une forme complémentaire à celle de la colonne 20.

Par exemple, la colonne présente une forme tubulaire avec une section transversale en forme de quadrilatère, tel qu'un rectangle.

Dans des modes de réalisation, la pièce 22 présente une forme allongée avec une section transverse en forme de U ou de C.

La pièce 22 est configurée pour être rigide et pour permettre de ménager un espace à l'arrière (dans le fond de l'armoire électrique 2) pour permettre le passage de câbles électriques.

De façon particulièrement avantageuse, la colonne 20 est monobloc, c'est à dire qu'elle est réalisée d'un seul tenant, en une seule pièce mécanique. Ainsi, il n'est pas nécessaire d'assembler plusieurs pièces distinctes pour obtenir la colonne 20 lors de l'installation de l'armoire électrique 2. Il n'y a donc pas besoin de gérer plusieurs références de pièces distinctes, ce qui simplifie la logistique et la construction de l'armoire électrique 2.

La colonne 20 est configurée de façon à permettre une isolation électrique de classe II au sens de la norme IEC 61140 de la Commission Électrotechnique Internationale (par exemple dans sa version « 2016 » de janvier 2016), c'est-à-dire de façon à empêcher un utilisateur d'entrer accidentellement en contact avec un conducteur électrique exposé à l'intérieur de la colonne 20, notamment grâce à l'utilisation d'une pièce de jonction, comme on va le comprendre à la lecture de la description qui va suivre.

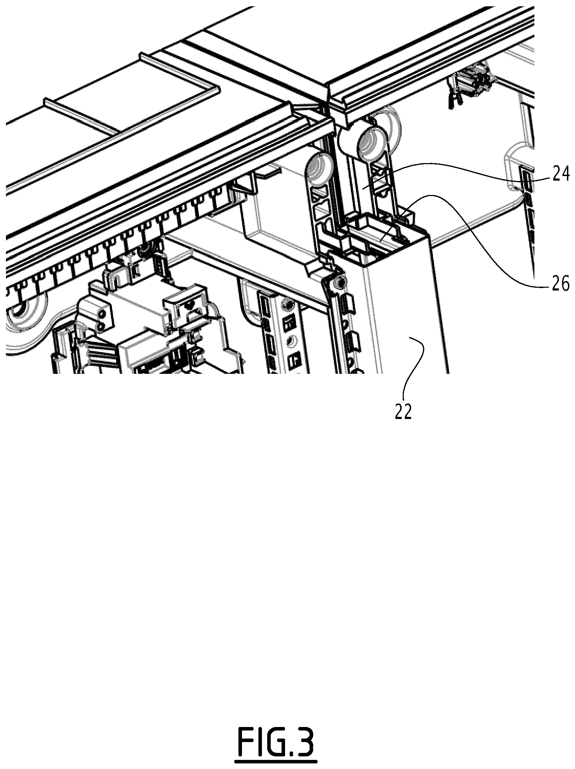

La figure 3 est une vue détaillée de la zone III visible en traits pointillés sur la figure 2, qui illustre plus en détail une extrémité supérieure de la colonne 20 lorsque la colonne est installée en position de fonctionnement dans l'armoire électrique 2.

Dans cette description, les termes définissant une position, tels que « supérieur », « inférieur », « haut », « bas », « avant », « arrière », sont préférentiellement définis en référence à une position de fonctionnement de l'armoire électrique 2, c'est-à-dire une position dans laquelle l'armoire électrique 2 est installée lorsqu'elle est en fonctionnement.

La position de fonctionnement peut s'agir d'une position fixée à un mur ou à un support ou fixée sur le sol. Généralement, l'armoire électrique 2 est installée verticalement, de sorte que les montants latéraux de l'armoire électrique 2 sont orientés verticalement.

Comme illustré sur la figure 3, l'armoire électrique 2 comporte une pièce de jonction 26 qui est insérée dans la partie supérieure de la colonne 20, de manière à fermer l'extrémité supérieure de la colonne 20 et lier mécaniquement la colonne 20 avec des montants frontaux 24 de l'armoire électrique 2 (tels que des montants supérieurs de l'armature de l'armoire électrique 2).

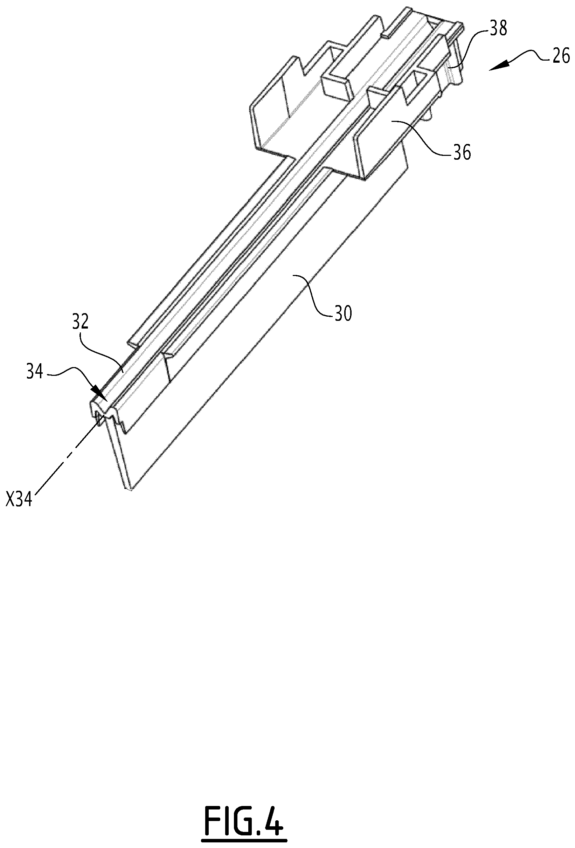

La figure 4 représente plus en détail un exemple de la pièce de jonction 26.

La pièce de jonction 26 comporte un corps 30 longitudinal en forme de lame qui s'étend longitudinalement selon un axe longitudinal X34 de la pièce.

La pièce de jonction 26, lorsqu'elle est insérée dans la colonne 20, s'étend de telle sorte que l'axe longitudinal X34 est orthogonal ou essentiellement orthogonal à la colonne 20.

Par exemple, la pièce de jonction 26 est réalisé en matière plastique, par exemple en polyamide PA 6.6 ou tout matériau équivalent.

De préférence, la longueur de la pièce de jonction 26 est au moins supérieure à 20% de la longueur de la colonne 20. Dans certains modes de réalisation, la pièce 26 peut s'étendre sur toute la longueur de la colonne 20.

La pièce de jonction comporte également, sur un des bords du corps 30 en forme de lame, des lèvres 32 qui délimitent une gorge 34 centrale.

Les lèvres 32 s'étendent ici parallèlement à l'axe longitudinal X34, de part et d'autre dudit bord du corps 30 en forme de lame, sur au moins une partie de la longueur du corps 30, mais pas nécessairement sur toute la longueur dudit bord du corps 30.

Les lèvres 32 s'étendent ici depuis une première extrémité du corps 30 en direction d'une deuxième extrémité opposée du corps 30.

Comme visible sur l'exemple illustré, les lèvres 32 présentent une forme arrondie et sont disposées symétriquement de part et d'autre dudit bord du corps 30 en forme de lame.

Par exemple, la forme arrondie des lèvres 32 est plus particulièrement visible du côté de la première extrémité du corps 30.

Ainsi, la gorge 34 est disposée en position centrale, par exemple le long du bord de la partie de base longitudinale 40, et s'étend le long de la pièce de jonction 26. Les lèvres 32 sont ici disposées de part et d'autre de la gorge 34, au moins le long d'une partie de la longueur de la gorge 34.

Optionnellement, la pièce de jonction 26 peut aussi comporter des portions complémentaires s'étendant en saillie à partir des lèvres 32 de part et d'autre dudit bord du corps 30, en étant disposées symétriquement de part et d'autre dudit bord du corps 30.

En variante, les portions complémentaires pourraient être omises.

La pièce de jonction 26 comporte également, sur sa deuxième extrémité, une portion d'extrémité 36 comportant des griffes de fixation 38.

Par exemple, la portion d'extrémité 36 comporte une portion de base et des parois latérales. La portion de base est disposée dans le prolongement des lèves 32, en s'étendant parallèlement à l'axe longitudinal X34 tout en étant disposée perpendiculairement au corps en forme de plaque 30. Les parois latérales 36 sont quant à elle disposées parallèlement au corps en forme de plaque 30, en s'étendant depuis des bords externes de la portion de base.

Dans des modes de réalisation, la portion de base a une largeur supérieure à la largeur des lèvres 32. Par exemple, la plus petite distance mesurée entre une paroi latérale et le plan géométrique médian de la pièce de jonction 26 (ce plan comportant l'axe longitudinal X34) est supérieur d'au moins deux fois, voire d'au moins trois fois, la distance comparable entre le bord distal d'une lèvre 32 et ledit plan.

Avantageusement, la gorge 34 se prolonge à l'intérieur de la portion d'extrémité 36, de préférence jusqu'à la deuxième extrémité de la pièce de jonction 26, c'est-à-dire sur toute la longueur de la pièce de jonction 26.

Les griffes de fixation 38, dont la partie est visible sur la figure 3, sont configurées pour maintenir la pièce de jonction 26 en position et pour fermer l'extrémité supérieure de la colonne 20.

Dans de nombreux exemples, une fois la pièce de jonction 26 insérée dans la colonne 20, les griffes de fixation 38 exercent une pression contre la colonne 20, notamment contre les parois de la colonne 20, de manière à prévenir tout mouvement non autorisé de la pièce de jonction 26 par rapport à la colonne 20, tel qu'un glissement de la pièce de jonction 26 ou un retrait inopiné de la pièce de jonction 26.

Par exemple, les griffes de fixation 38 peuvent en partie s'appuyer sur un montant de l'armoire électrique 2 (tel que le montant supérieur de l'armoire).

Selon un exemple, les griffes de fixation 38 peuvent dépasser au moins en partie de l'extrémité supérieure de la colonne 20 et peuvent ainsi s'appuyer sur le bord supérieur de la colonne 20 et/ou sur le bord supérieur du longeron 22.

On comprend que, quand la pièce de jonction 26 est insérée dans la colonne 20, la première extrémité de la pièce de jonction 26 est tournée vers le bas de l'armoire électrique 2, tandis que la deuxième extrémité de la pièce de jonction 26 correspond à une extrémité supérieure tournée vers le haut de l'armoire électrique 2.

La pièce de jonction 26 permet ainsi, grâce à sa forme et à la présence des griffes de fixation 38, d'assurer une rigidité mécanique qui renforce la tenue mécanique de la colonne 20, notamment pour diminuer le jeu mécanique entre la colonne 20 et l'armoire électrique 2.

La pièce de jonction 26 permet aussi d'assurer une isolation électrique de classe II, en empêchant un utilisateur (ou un outil de l'utilisateur) de pénétrer à l'intérieur de la colonne 20 lorsque la pièce de jonction 26 est insérée dans la colonne 20.

Enfin, la pièce de jonction 26 permet d'assurer une étanchéité contre les liquides en collectant l'eau, qui pourrait s'introduire dans l'armoire électrique 2, par exemple résultant de la condensation ou un écoulement d'origine externe. La gorge 34 permet d'évacuer cette eau hors de la colonne, vers l'arrière de l'armoire électrique 2. Les lèvres 32 facilitent la collecte de l'eau ainsi que son évacuation hors de la colonne 20.

Par exemple, la pièce de jonction 26 permet d'obtenir une étanchéité à l'humidité correspondant à un indice de protection au moins égal à l'indice IPX1, tel que défini par la norme EN 60529.

Enfin, la pièce de jonction 26 est construite d'un seul tenant (par exemple par moulage ou par injection) de sorte que son assemblage s'en trouve simplifié, par comparaison au cas où la pièce de fixation 26 devrait être assemblée mécaniquement à partir d'une pluralité de composants individuels.

Grâce à l'invention, la construction de l'armoire électrique 2, et notamment de l'association de la pièce de fixation 26 avec la colonne 20 permet d'obtenir une isolation électrique de classe II dans l'armoire, tout en ayant une armoire électrique 2 qui soit simple à fabriquer, notamment grâce au fait que le nombre de pièces requis pour assembler l'armoire électrique 2 est particulièrement réduit.

En proposant une pièce qui remplace un assemblage ad hoc de plusieurs pièces tel qu'on le connaît dans des situations existantes, cela facilite la gestion de la production, ainsi que la gestion des stocks, et rend la construction de l'armoire électrique 2 plus aisée pour un installateur.

De nombreux autres modes de réalisation sont possibles.

Toute caractéristique de l'un des modes de réalisation ou variante décrite ci-dessus, peut être mise en œuvre dans les autres modes de réalisation et variantes décrits, toujours dans l'étendue de la protection définie par les revendications.

## Revendications

1. Armoire électrique (2) comportant des parois (4) qui délimitent un volume intérieur configuré pour recevoir au moins un appareil électrique, l'armoire électrique comportant également une colonne (20) pour recevoir au moins un câble électrique, la colonne étant disposée verticalement à l'intérieur de l'armoire électrique, dans laquelle l'armoire électrique comporte également une pièce de jonction (26) insérée dans une extrémité supérieure de la colonne (20), de manière à fermer l'extrémité supérieure de la colonne, la pièce de jonction (26) présentant une forme longitudinale et comportant un corps (30) longitudinal en forme de lame, la pièce de jonction s'étendant orthogonalement à la colonne lorsque la pièce de jonction est insérée dans la colonne, la pièce de jonction (26) comportant une gorge centrale (34) s'étendant le long de la pièce de jonction des lèvres (32) disposées de part et d'autre de la gorge (34), au moins le long d'une partie de la longueur de la gorge,
**caractérisée en ce que**:
l'armoire électrique (2) présente une isolation de Classe II au sens de la norme IEC 61140:2016 de la Commission Électrotechnique Internationale,
la gorge centrale (34) est configurée pour évacuer de l'eau hors de la colonne vers l'arrière de l'armoire électrique, et
les lèvres (32) sont configurées pour faciliter la collecte de l'eau ainsi que son évacuation hors de la colonne (20).

2. Armoire électrique (2) selon la revendication 1, dans laquelle la pièce de jonction (26) comporte des griffes de fixation (38) configurées pour exercer un effort sur la colonne (20) lorsque la pièce de jonction est insérée dans la colonne.

3. Armoire électrique (2) selon la revendication précédente, dans laquelle les griffes de fixation (38) sont configurées pour dépasser au moins en partie de l'extrémité supérieure de la colonne (20) pour s'appuyer sur un bord supérieur de la colonne.

4. Armoire électrique (2) selon l'une quelconque des revendications précédentes, dans laquelle la pièce de jonction (26) est une pièce monobloc construite d'un seul tenant.

5. Armoire électrique (2) selon l'une quelconque des revendications précédentes, dans laquelle la pièce de jonction (26) est construite en matière plastique, par exemple par moulage ou par injection.

## Patentansprüche

1. Schaltschrank (2), umfassend Wände (4), die ein Innenvolumen begrenzen, das konfiguriert ist, um mindestens ein Schaltgerät aufzunehmen, der Schaltschrank auch umfassend eine Säule (20) zum Aufnehmen mindestens eines Stromkabels, wobei die Säule vertikal im Inneren des Schaltschranks angeordnet ist, wobei der Schaltschrank auch ein Verbindungsstück (26) umfasst, das in ein oberes Ende der Säule (20) eingesetzt ist, um das obere Ende der Säule zu schließen,
wobei das Verbindungsstück (26)
eine Längsform aufweist und einen Längskörper
(30) in Form einer Kling umfasst, wobei sich das Verbindungsstück orthogonal zu der Säule erstreckt, wenn das Verbindungsstück in die Säule eingesetzt ist, das Verbindungsstück (26) umfassend
eine mittlere Nut (34), die sich entlang des Verbindungsstücks erstreckt,
Lippen (32), die auf beiden Seiten der Nut (34) angeordnet sind, zumindest entlang eines Teils der Länge der Nut,
**dadurch gekennzeichnet, dass**:
der Schaltschrank (2) eine Isolierung der Klasse II im Sinne der IEC-Norm 61140:2016 der Internationalen Elektrotechnischen Kommission aufweist,
die zentrale Nut (34) konfiguriert ist, um Wasser aus der Säule in Richtung der Rückseite des Schaltschranks abzuleiten, und
die Lippen (32)
konfiguriert sind, um das Sammeln von Wasser sowie dessen Ableiten aus der Säule (20) zu ermöglichen.

2. Schaltschrank (2) nach Anspruch 1, wobei das Verbindungsstück (26) Befestigungsklauen (38) aufweist, die konfiguriert sind, um eine Kraft auf die Säule (20) ausüben, wenn das Verbindungsstück in die Säule eingeführt wird.

3. Schaltschrank (2) nach dem vorherigen Anspruch, wobei die Befestigungsklauen (38) konstruiert sind, um zumindest teilweise über das obere Ende der Säule (20) hervorzustehen, um an einem oberen Rand der Säule anzuliegen.

4. Schaltschrank (2) nach einem der vorherigen Ansprüche, wobei das Verbindungsstück (26) ein einstückiges Teil ist, das in einem Stück gebaut ist.

5. Schaltschrank (2) nach einem der vorherigen Ansprüche, wobei das Verbindungsstück (26) aus Kunststoff gebaut ist, beispielsweise durch Gießen oder Spritzgießen.

## Claims

1. An electrical cabinet (2) comprising walls (4) which delimit an interior volume configured to receive at least one electrical appliance, the electrical cabinet also comprising a column (20) for receiving at least one electrical cable, the column being arranged vertically inside the electrical cabinet, in which the electrical cabinet also comprises a junction piece (26) inserted into an upper end of the column into an upper end of the column (20), so as to close the upper end of the column,
the junction piece (26) has
a longitudinal shape and comprising a body
(30), the joining piece extending orthogonally to the column when the joining piece is inserted in the column, the joining piece (26) comprising
a central groove (34) extending along the junction piece
lips (32) arranged on either side of the groove (34), at least along part of the length of the groove,
**characterised in that**:
the electrical cabinet (2) has Class II insulation within the meaning of the IEC standard 61140:2016 of the International Electrotechnical Commission,
the central groove (34) is configured to drain water out of the column towards the rear of the switchgear cabinet, and
the lips (32) are
configured to facilitate the collection of water and its evacuation from the column (20).

2. An electrical cabinet (2) according to claim 1, in which the junction piece (26) comprises fixing claws (38) configured to exert a force on the column (20) when the junction piece is inserted into the column.

3. An electrical cabinet (2) according to the preceding claim, in which the fixing claws (38) are configured to project at least in part from the upper end of the column (20) to bear on an upper edge of the column.

4. An electrical cabinet (2) according to any one of the preceding claims, in which the junction piece (26) is a monobloc built in one piece.

5. An electrical cabinet (2) according to any one of the preceding claims, in which the junction piece (26) is made of plastic, for example by moulding or injection moulding.
